(19) Europäisches Patentamt
European Patent Office
Office européen des brevets

(11) **EP 2 783 464 B1**

(12) **EUROPÄISCHE PATENTSCHRIFT**

(45) Veröffentlichungstag und Bekanntmachung des Hinweises auf die Patenterteilung:
**15.03.2017 Patentblatt 2017/11**

(21) Anmeldenummer: **11794667.3**

(22) Anmeldetag: **24.11.2011**

(51) Int Cl.:
***H03K 17/16*** *(2006.01)*

(86) Internationale Anmeldenummer:
**PCT/EP2011/070988**

(87) Internationale Veröffentlichungsnummer:
**WO 2013/075749 (30.05.2013 Gazette 2013/22)**

(54) **ELEKTRONISCHER SCHALTKREIS UND VERFAHREN ZUM ANSTEUERN EINES HALBLEITERSCHALTERS**

ELECTRONIC CIRCUIT AND METHOD FOR TRIGGERING A SEMICONDUCTOR SWITCH

CIRCUIT ÉLECTRONIQUE ET PROCÉDÉ DE COMMANDE D'UN CIRCUIT ÉLECTRONIQUE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(43) Veröffentlichungstag der Anmeldung:
**01.10.2014 Patentblatt 2014/40**

(73) Patentinhaber: **EBM-Papst Mulfingen GmbH&CO. KG**
**74673 Mulfingen (DE)**

(72) Erfinder:
• **LIPP, Helmut**
  **74677 Dörzbach-Hohebach (DE)**
• **WYSTUP, Ralph**
  **74653 Künzelsau (DE)**
• **SCHNEIDER, Fabian**
  **74585 Rot am See (DE)**
• **SCHROTH, Sebastian**
  **74635 Kupferzell (DE)**

(74) Vertreter: **Peter, Julian**
**Staeger & Sperling**
**Partnerschaftsgesellschaft mbB**
**Sonnenstrasse 19**
**80331 München (DE)**

(56) Entgegenhaltungen:
**WO-A1-2008/032113    US-A- 5 801 458**

EP 2 783 464 B1

**Beschreibung**

Die vorliegende Erfindung betrifft zunächst gemäß dem Oberbegriff des Anspruchs 1 einen elektronischen Schaltkreis, insbesondere als Bestandteil einer elektronischen Umrichterschaltung vorzugsweise zum Betrieb von EC-Motoren, wobei der Schaltkreis mindestens einen mit seiner Schaltstrecke in Reihe zu einer anzusteuernden induktiven Last liegenden Halbleiterschalter und mindestens ein während Schaltphasen mit dem Halbleiterschalter zusammenwirkendes und dabei ebenfalls in Reihe zu der Last liegendes Freilaufelement aufweist.

Ferner betrifft die Erfindung auch gemäß dem Oberbegriff des Anspruchs 4 ein neuartiges Verfahren zum Ansteuern eines Halbleiterschalters, der in einem solchen Schaltkreis mit seiner Schaltstrecke in Reihe zu einer anzusteuernden induktiven Last liegt, und der während Umschaltphasen mit einem dabei ebenfalls in Reihe zu der Last liegenden Freilaufelement zusammenwirkt.

Beim Schalten von induktiven Lasten, wie insbesondere beim elektronischen Umkommutieren des Stromflusses der Wicklung(en) von EC-Motoren, werden in aller Regel als Halbleiterschalter moderne Leistungshalbleiter in Kombination mit dazu parallelen Freilaufelementen, in aller Regel Freilaufdioden, verwendet. Üblich sind Leistungstransistoren, wie MOSFET oder IGBT.

Der oder die Halbleiterschalter werden jeweils zum Umschalten bzw. zur Umkommutierung über dessen Steueranschluss mit Steuersignalen angesteuert, die üblicherweise von einem Mikrocontroller erzeugt und dann einer Treiberschaltung zugeführt werden, die dann den jeweiligen Halbleiterschalter ein- und ausschaltet.

Um Schaltverluste von Leistungshalbleitern minimal zu halten, ist es bekannt, die Leistungshalbleiter möglichst schnell aus- und einzuschalten. Durch diese Maßnahme wird wenig Verlustleistung erreicht, und Kühlmittel können entsprechend klein gehalten werden.

Nachteilig bei schnellem Ein- und Ausschalten von induktiven Verbrauchern ist, dass durch die steilen Flanken beim Schalten eines Leistungstransistors Störspannungen erzeugt werden, welche durch so genannte EMV-Filter wieder gedämpft werden müssen.

Das Störspektrum, die so genannten EMV-Störungen, bilden sich beim Ein- und Ausschalten der Leistungshalbleiter als hochfrequente Störungen aus. Die Grenzwerte solcher Störspektren sind in bestimmten EN-Normen festgelegt und dürfen nicht überschritten werden. Daher ist es in vielen Fällen in der Praxis erforderlich, aufwändige großvolumige EMV-Filter aufzubauen, die sehr viel Bauraum benötigen und hohe Kosten verursachen. EMV-Filter sind in der Regel passive Bauteile, üblicherweise eine Kombination aus Induktivitäten und Kapazitäten.

Der vorliegenden Erfindung liegt die Aufgabe zu Grunde, unter Gewährleistung von minimalen Schaltverlusten durch möglichst schnelles Ein- und Ausschalten des jeweiligen Halbleiterschalters ohne aufwändige EMV-Filterung hochfrequente Störungen zu vermeiden oder zumindest zu minimieren. Mit anderen Worten sollen bei minimaler Verlustleistung Störspektren bei den Schaltflanken vermieden werden, um EMV-Bauteile einsparen zu können.

Diese Aufgabe wird durch die Merkmale jedes der beiden unabhängigen Ansprüche 1 und 4 gelöst. Vorteilhafte Ausgestaltungen sind in den jeweils abhängigen Ansprüchen enthalten.

Die Erfindung enthält demnach eine Steuerung, wobei ein Steueranschluss des Halbleiterschalters mit einem variablen Steuerstrom in Abhängigkeit vom zeitlichen Verlauf einer an dem zugehörigen Freilaufelement gemessenen Spannung angesteuert wird. Durch diese Maßnahme kann der Verlauf der jeweiligen Schaltflanke im oberen Bereich moduliert werden. Eine ähnliche Schaltung ist in US 5,801,458 gezeigt.

Zusätzlich ist die Steuerung so ausgelegt, dass sie den Halbleiterschalter mit einem variablen Steuerstrom in Abhängigkeit vom zeitlichen Verlauf einer an der Schaltstrecke des Halbleiterschalters gemessenen Spannung ansteuert. Durch diese Maßnahme kann die jeweilige Schaltflanke in ihrem unteren Bereich moduliert werden. Durch jede der beiden Maßnahmen wird eine dB-Spektralabsenkung erreicht.

Erfindungsgemäß werden beide Maßnahmen miteinander kombiniert, indem die Steuerung einerseits die Spannung an dem Freilaufelement sowie andererseits auch die Spannung an der Schaltstrecke des anzusteuernden Halbleiterschalters misst, wobei während Umschaltphasen bei einem bestimmten Verhältnis der beiden gemessenen Spannungen die Abhängigkeit des Steuerstroms über ein Umschaltglied von der einen Spannung auf die andere Spannung gewechselt wird. Auf diese Weise können die Schaltflanken sowohl im unteren als auch im oberen Bereich vorteilhaft moduliert werden, um Störspektren zu vermeiden oder zumindest zu reduzieren.

Anhand der anschließenden Beschreibung soll die Erfindung beispielhaft genauer erläutert werden. Hierbei zeigen:

Fig. 1                    ein Ersatzschaltbild eines beispielhaften Schaltkreises,

Fig. 2                    ein weiteres Ersatzschaltbild zusammen mit einem Blockschaltbild einer beispielhaften Steuerung in einer ersten Ausführung,

Fig. 3                    eine Darstellung analog zu Fig. 2 in einer zweiten beispielhaften Ausführung der Steuerung,

Fig. 4 mit den Teilfiguren 4 a bis 4d      Diagramme zur Veranschaulichung der Beeinflussung der Schaltflanken durch die gezeigten Maßnahmen,

Fig. 5 und 6      weitere Ersatzschaltbilder des Schaltkreises,

Fig. 7      ein weiteres Ersatzschaltbild mit zwei in einer Teilbrücke geschalteten Halbleiterschaltern,

Fig. 8      ein prinzipielles Schaltbild einer dreiphasigen Umrichterschaltung für einen EC-Motor,

Fig. 9      ein weiteres Diagramm eines Schaltimpulses,

Fig. 10 bis 13      jeweils eine weitere Darstellung analog zu Fig. 2 und 3 in erfindungsgemäßen Ausgestaltungen und

Fig. 14      ein weiteres Diagramm einer möglichen Schaltflanken-Modulation.

In den verschiedenen Figuren der Zeichnung sind gleiche Teile stets mit den gleichen Bezugszeichen versehen.

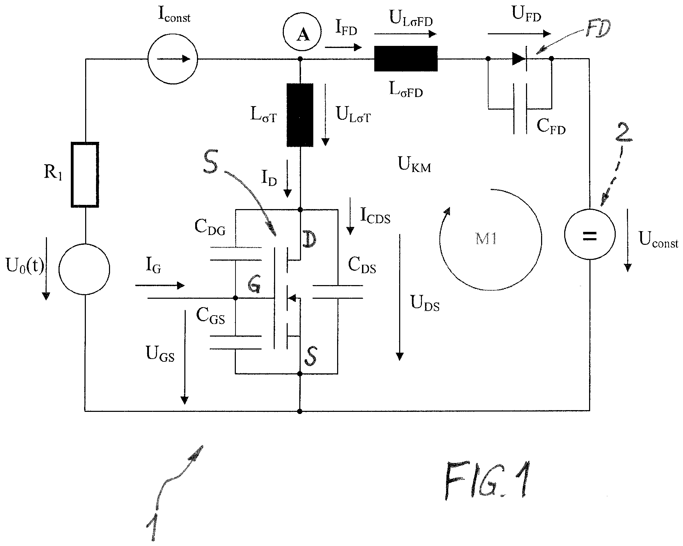

In Fig. 1 ist ein beispielhafter Schaltkreis 1 als Ersatzschaltbild dargestellt, und zwar in einer minimalen Ausführung als eine so genannte "elementare Schaltzelle". In einer Konstantspannungsquelle $U_{const}$ wird die Wirkleistung

$$P = \frac{U_{const}}{T} \cdot \int_T I_{FD}(t) \cdot dt$$ umgesetzt. Infolge der hier möglichen Stromrichtung durch eine Freilaufdiode FD wird Wirkleistung aus dem System entnommen, was dem Verhalten eines Verbrauchers 2 gleichbedeutend ist.

Die Konstantstromquelle $I_{const}$ repräsentiert hier aufgrund der Stromflussrichtung eine Energiequelle, indem sie das Verhalten eines induktiven Blindwiderstands während des Schaltvorgangs nachbildet. Die Spannung $U_0(t)$ kann beliebig sein, ebenso der Widerstand $R_1$. Der Halbleiterschalter S ist mit seinen parasitären Kapazitäten dargestellt.

Da auch parasitäre Elemente $L_{\sigma FD}$, $L_{\sigma T}$ je nach Schaltungsausführung immer mehr oder weniger stark ausgeprägt vorhanden sind, liegt das Freilaufelement, hier die Diode FD immer in Reihe zu dem Verbraucher 2 bzw. $U_{const}$, was durch die eingezeichnete Masche M1 ersichtlich ist. Die parasitären Elemente $L_{\sigma FD}$, $L_{\sigma T}$ können dabei einem beliebigen Stück Leitung zugeordnet werden. Die parasitäre Kapazität $C_{FD}$ ist Bestandteil der Freilaufdiode FD und nicht trennbar von ihr. Dasselbe gilt für die drei hier eingezeichneten parasitären Kapazitäten des Transistors S. Die hier beschriebene Reihenschaltung zeichnet sich, wie allgemein bekannt, dadurch aus, dass der gleiche Strom durch das Freilaufelement FD, den Verbraucher 2 und die parasitären Elemente sowie in Teilen durch das zugehörige Schaltmittel S, hier den Transistor, fließt. In Teilen bedeutet unter Beachtung der Knotenregel im Punkt A in Fig. 1.

Auf der Basis dieser "elementaren Schaltzelle" nach Fig. 1 soll nun die praktische Umsetzung eines erfindungsgemäßen Steuerverfahrens zur Ansteuerung eines Halbleiterschalters aufgezeigt werden.

Vorstellung eines Ansteuerungsschemas für die Reduktion von Schwingungsanregungen während der Schaltvorgänge bzw. zur Erzeugung spezieller Pulsformen

Auf Basis der vorhandenen Einflussfaktoren der durch das Schalten des Transistors ausgelösten parasitären Schwingungsanregung wird im Folgenden ein Ansteuerungsentwurf für die gegebene Schaltungstopologie vorgestellt.

Ein Novum dabei ist, dass während des Betriebes die Zielsetzung der Ansteuerung dynamisch geändert werden kann. Dies kann durch Änderung der gezielten Pulsformung des Schaltvorganges erreicht werden.

Mögliche Zielsetzungen sind dabei:

1) Reduktion der Schwingungen infolge vorhandener parasitärer Elemente.
2) Reduktion der Schaltverluste
3) Reduktion des EMV Spektrums
4) Eine Kombination aus den oben beschrieben Punkten mit reduzierter Erfüllung der Einzelziele.

Diese neue Dynamik ermöglicht es, bei unterschiedlichen Betriebsverhalten der zu steuernden Last 2 unterschiedlich reagieren zu können. Ist beispielsweise die maximale zulässige Temperatur der Elektronik in einem heißen Umgebungsklima überschritten, kann zur Sicherung des Totalausfalls der Anlage, die EMV Aussendung zugunsten der Temperatursenkung erhöht werden.

Bei der im Folgenden vorgestellten Ansteuerung wird der Gatestrom des Transistors S durch eine geeignete Schaltung variabel eingeprägt, wobei eine Proportionalität einen Sonderfall darstellt. Proportionalität besteht zwischen zwei veränderlichen Größen, wenn sie immer im gleichen Verhältnis zueinander stehen. Variabel bedeutet allgemein eine Funktion, welche sich auch als Polynom beschreiben lässt.

Der Gatestrom setzt sich für die beiden Schaltvorgänge jeweils aus einem Konstantstrom und dem beschriebenen variablen Anteil zusammen. Der variable Anteil des eingeprägten Gatestromes ist hierbei eine Funktion der Spannung an der jeweils am Kommutierungsvorgang des Stromes beteiligten Freilaufdiode FD. Dabei kann die Funktion, als Sonderfall eines Polynoms, proportional sein oder grundsätzlich ein Polynom höherer Ordnung beschreiben. Die Ein- und Ausschaltvorgänge unterscheiden sich hierbei lediglich durch den Wert des Konstantstromes und durch die Funktion, welche die Spannung an der zugehörigen Freilaufdiode in den variablen Stromanteil umsetzt. D.h. der Gatestrom ergibt sich allgemein zu

$$i_G(t) = \begin{cases} I_{const_{ON}} + f_{ON}(u_{FD}) & \text{Einschalten} \\ I_{const_{OFF}} + f_{OFF}(u_{FD}) & \text{Ausschalten} \end{cases}$$

Dieser Gatestrom wird solange eingeprägt, bis die Gate-Source-Spannung an festgelegte Grenzen $U_{GSmax}$ und $U_{GSmin}$ stößt. Die Stromeinprägung kann dabei durch eine Regelung erfolgen oder durch eine Stromspiegelschaltung. Werden die Grenzen erreicht, wird der Gatestrom zu Null. Weicht die Spannung davon ab, so wird wieder der entsprechende Gatestrom eingeprägt. Im einfachsten Fall sind die Grenzen durch die Betriebsspannung der realisierten Gate-Ansteuerungsschaltung festgelegt. Der Schaltzustandswunsch (SZW) wird der Ansteuerung extern vorgegeben und bedingt intern ein Umschalten zwischen den Gatestromdefinitionen, was den kontrollierten Umschaltvorgang auslöst.

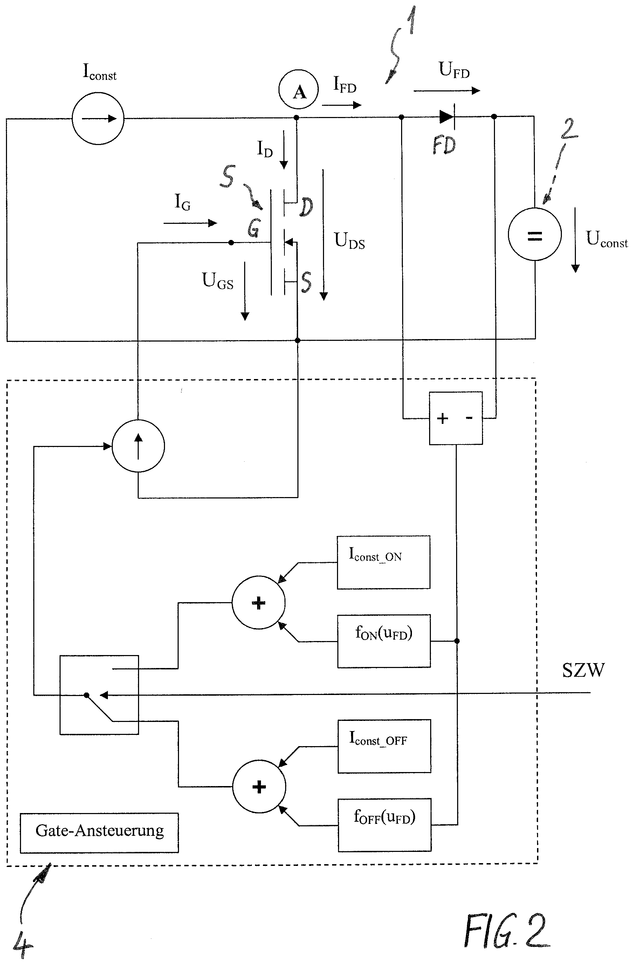

In Fig. 2 ist eine beispielhafte Steuerung 4 in einer ersten Ausführung in Verbindung mit der Schaltungstopologie der Schaltzelle nach Fig. 1 dargestellt.

Im einfachsten Fall stellen die Funktionen der Freilaufdiodenspannung einen konstanten Gewichtungsfaktor dar, d.h.

$$f_{ON}(u_{FD}) = G_{ON} \cdot u_{FD}(t)$$

$$f_{OFF}(u_{FD}) = G_{OFF} \cdot u_{FD}(t)$$

und damit die Gatestromverläufe

$$i_G(t) = \begin{cases} I_{const_{ON}} + G_{ON} \cdot u_{FD}(t) & \text{Einschalten} \\ I_{const_{OFF}} + G_{OFF} \cdot u_{FD}(t) & \text{Ausschalten} \end{cases}$$

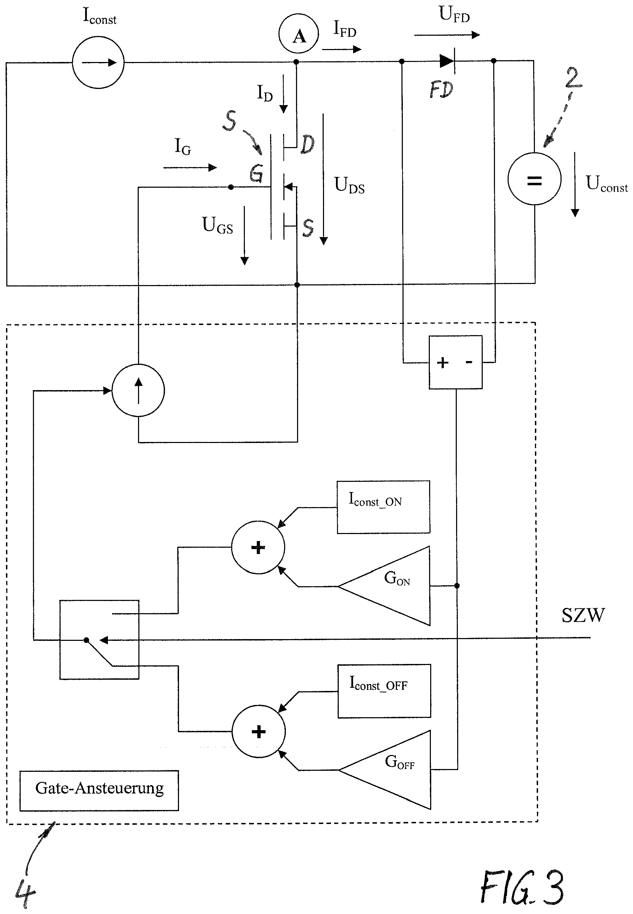

Hieraus ergibt sich eine vereinfachte Gateansteuerungsschaltung 4 nach Fig. 3.

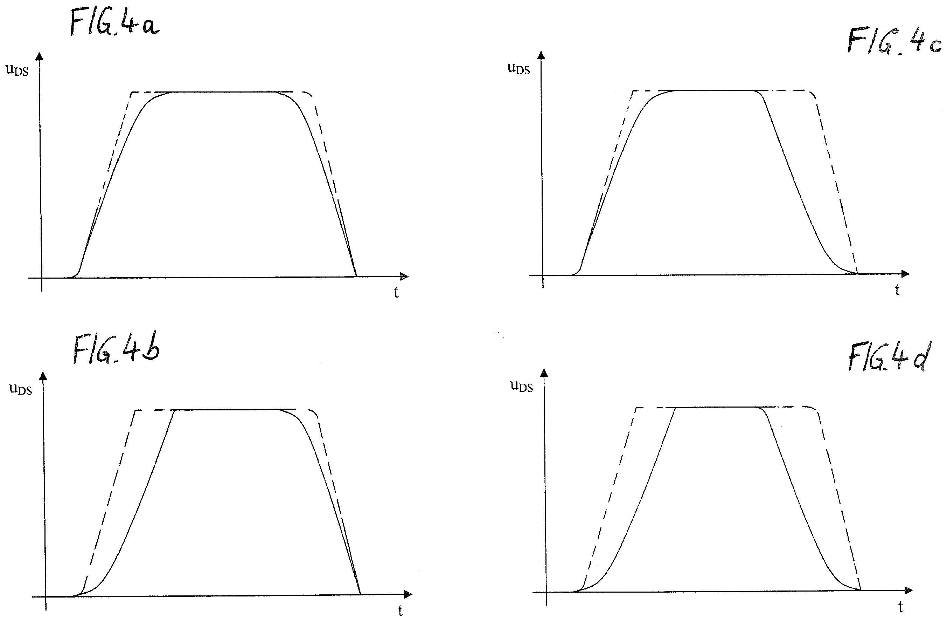

Durch entsprechende Festlegung der Konstantströme und Gewichtungsfaktoren, bzw. deren Vorzeichen kann eine entsprechende Pulsformung vorgenommen werden. Diese Pulsformen der Drain-Source-Spannung sind qualitativ im Vergleich zum Schalten eines über einen reinen Konstantstrom angesteuerten Transistors in Fig. 4a bis 4d dargestellt. Die qualitativen Einstellungen der jeweiligen zugehörigen Ansteuerungsparameter sind in der folgenden Tabelle 1 aufgelistet.

In Fig. 4a bis 4d sind qualitative Signalverläufe der Flanken beispielhaft dargestellt, und zwar jeweils im Vergleich zu den ursprünglichen, gestrichelt gezeichneten unbeeinflussten Pulsformen, z. B. nur mit Gate-Vorwiderstand.

Tabelle 1

| Verlauf nach | $I_{const\_OFF}$ | $G_{OFF}$ | $I_{const\_ON}$ | $G_{ON}$ |
|---|---|---|---|---|
| Fig. 4a | <0, ~0 | <0 | >0, ~0 | >0 |
| Fig. 4b | <0, <-$U_{const}$*$G_{OFF}$ | >0 | >0, ~0 | >0 |
| Fig. 4c | <0, ~0 | <0 | >0, >-$U_{const}$*$G_{ON}$ | <0 |

(fortgesetzt)

| Verlauf nach | $I_{const\_OFF}$ | $G_{OFF}$ | $I_{const\_ON}$ | $G_{ON}$ |
|---|---|---|---|---|
| Fig. 4d | $<0, <-U_{const}*G_{OFF}$ | $>0$ | $>0, >-U_{const}*G_{ON}$ | $<0$ |

Die nachfolgende <u>Tabelle 2</u> beschreibt die jeweiligen Vor- und Nachteile der Flankenmodulation in Abhängigkeit eines Bewertungsschemas:

Jede Rundung oben erbringt Vorteile (mit + bzw. ++, da oben nur zwei Flanken möglich sind) in der Vermeidung der Anregung parasitärer Schwingungen jedoch Nachteile (mit - bzw. --) bezüglich der Schaltverluste. Vorteile durch die Rundung der Flanken auf die Reduktion des EMV Störspektrums werden ebenfalls mit (mit + ... ++++ da vier Flanken) bezeichnet.

Dieses Bewertungsschema wird nun auf die gezeigten Pulsmuster angewendet:

Tabelle 2

| | Reduktion der Schwingungsanregung | Reduktion des EMV Spektrums | Erhöhung der Verlustleistung |
|---|---|---|---|
| Impuls ohne Rundung | 0 | 0 | 0 |
| Fig. 4a | ++ | ++ | - |
| Fig. 4b | + | ++ | - |
| Fig. 4c | + | ++ | - |
| Fig. 4d | 0 | ++ | 0 |
| Figur 9 | ++ | ++++ | -- |
| Figur 14 | ++ | ++++ | ++ |

<u>Beschreibung der Anwendbarkeit der erfindungsgemäßen Maßnahmen auf verschiedene Schaltungstopologien</u>

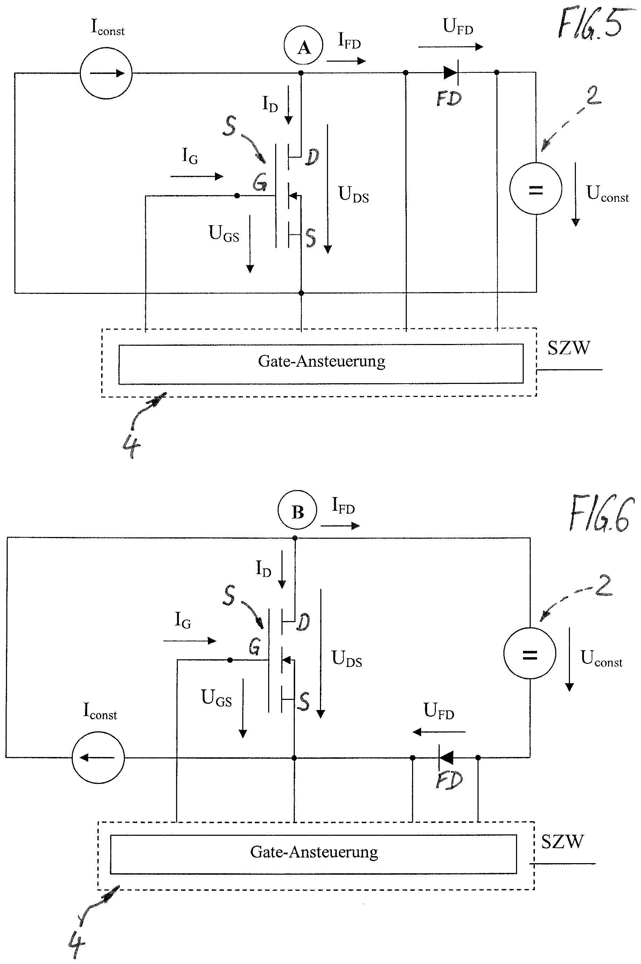

Grundsätzlich können die in der Schaltungstopologie nach Fig. 5 als Konstantstrom- und Spannungsquelle modellierten Pfade beliebige Schaltungsteile darstellen, solange diese im Moment des Schaltvorganges und dessen unmittelbarer zeitlicher Umgebung näherungsweise durch eine Konstantstrom-, bzw. Spannungsquelle nachgebildet werden können. D.h. z.B. kann die Konstantstromquelle der Pfad einer PFC-Drossel einer aktiven PFC-Schaltung oder der Anschluss eines Pfades einer Motorwicklung sein. Ebenso kann die Spannungsquelle eine Nachbildung eines Zwischenkreises eines Umrichters darstellen.

Des Weiteren kann die Schaltung durch Umformung in die Topologie nach Fig. 6 transformiert werden, in welcher die Gate-Ansteuerung analog eingesetzt werden kann.

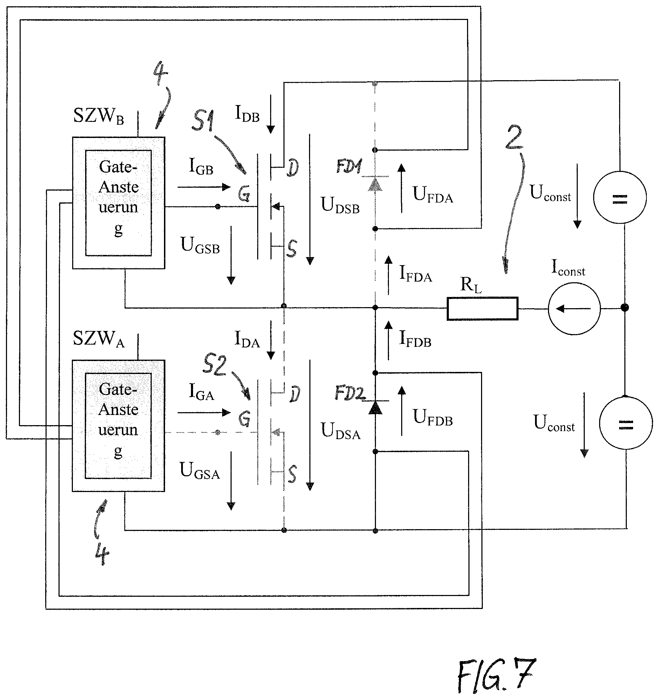

Durch Kombination der Topologien nach Fig. 5 und Fig. 6 ist auch der Einsatz der Ansteuerschaltung in Brückenschaltungen möglich. D.h. eine Teilbrücke setzt sich aus zwei Transistoren S1, S2 mit jeweils zugehöriger Freilaufdiode FD1, FD2 parallel zum gegenüberliegenden Transistor und zwei Ansteuerschaltungen zusammen. Diese Topologie ist in Fig. 7 dargestellt. Durch Kombination der Teilbrücken können beliebige Umrichter für ein oder mehrere Stränge optimiert angesteuert werden.

Der Widerstand $R_L$ repräsentiert allgemein eine Last der Form $R + u(t) \cdot I_{const}$, wobei u(t) eine beliebige Spannung sein kann (siehe den Aufbau der elementaren Schaltzelle in Fig. 1). Ein induktiver Anteil der Last wird durch den Strom $I_{const}$ berücksichtigt, welcher das Verhalten einer Induktivität im Schaltvorgang nachbildet. Aufgrund des durch die Topologie möglichen Stromflusses bildet hier die Spannungsquelle $U_{const}$ die Versorgung, während $R_L$ die Last 2 darstellt.

Um eine symmetrische Darstellung aus zwei Schaltzellen zu ermöglichen, wurde in Fig. 7 die Spannungsquelle $U_{const}$ in zwei Einzelquellen geteilt. Diese ändert am Verhalten der Schaltzelle nichts, ermöglicht aber zudem den symmetrischen Anschluss der Last $R_L$.

Aus Fig. 7 ist zu erkennen, dass egal welche Freilaufdiode welches dazugehörigen Schalttransistors gerade wirkt, die Last immer in Reihe zu dieser geschaltet ist.

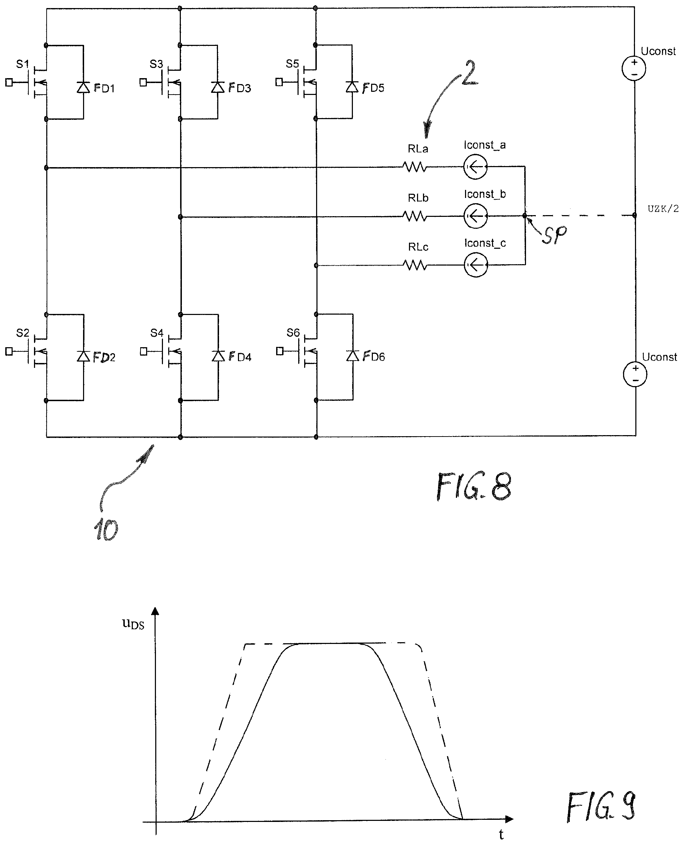

Für eine als dreiphasige Brückenschaltung aufgebaute Umrichterschaltung 10 ergibt sich somit ein Aufbau gemäß Fig. 8.

Eine Verbindung des Sternpunktes SP zum Punkt UZK/2 ist bei einer dreiphasigen Brücke nicht nötig, da der jeweilige Konstantstrom während der Kommutierung über die beiden anderen Phasen fließen kann.

Auch bei dieser Brückenschaltung sind die Last und die jeweilige Freilaufdiode des einen Brückenzweiges über die anderen Transistoren der anderen beiden Brückenzweige in Reihe geschaltet.

Erweiterung des Ansteuerschemas um die Erfassung der Drain-Source-, bzw. Kollektor-Emitter-Spannung und die Integration dieser in die aktive Schaltflankenformung

Durch eine zusätzliche Erfassung der Drain-Source-Spannung ergänzend zur Freilaufdiodenspannung wird ein weiterer Freiheitsgrad in der aktiven Schaltflankenformung gewonnen. Zum einen können alle auf Basis der reinen Freilaufdiodenspannung geformten Schaltflanken auch über die reine Erfassung der Drain-Source-Spannung erzeugt werden. Zusätzlich können durch die nun mögliche Kombination beider Spannungen auch Flanken mit am oberen und unteren Ende "gerundeten" Verläufen erzeugt werden. Dies kann unter Kenntnis der Konstantspannung $U_{const}$ auch über die reine Erfassung einer der beiden Spannungen erreicht werden, jedoch weist die Flankenformung auf Basis einer Rückführung beider Signale eine größere Parameterunabhängigkeit auf.

Mit dem im Folgenden vorgestellten Ansteuerschema wird eine Flankenformung beispielsweise nach Fig. 9 ermöglicht.

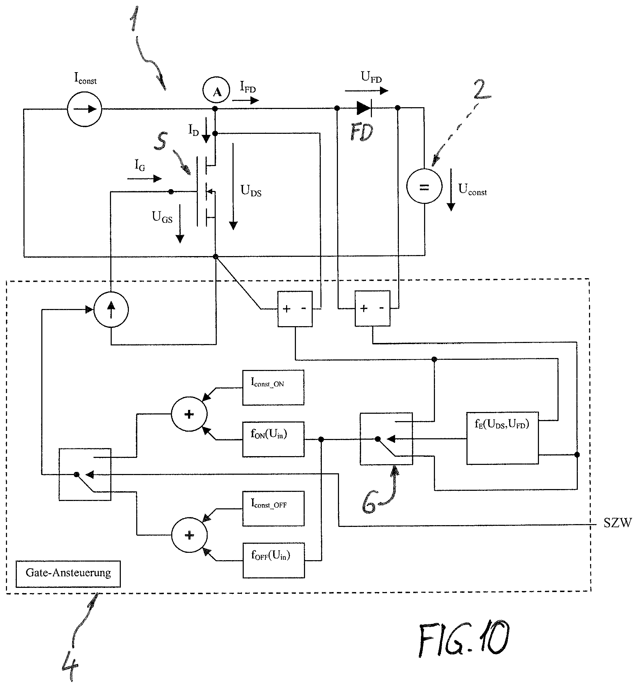

Das für diese Flankenformung genutzte erfindungsgemäße Ansteuerungsschema ist in Fig. 10 dargestellt. Die Messung der Spannung $U_{DS}$ erfordert bei einem ersten Einschaltvorgang einen Initial-Gatestrom.

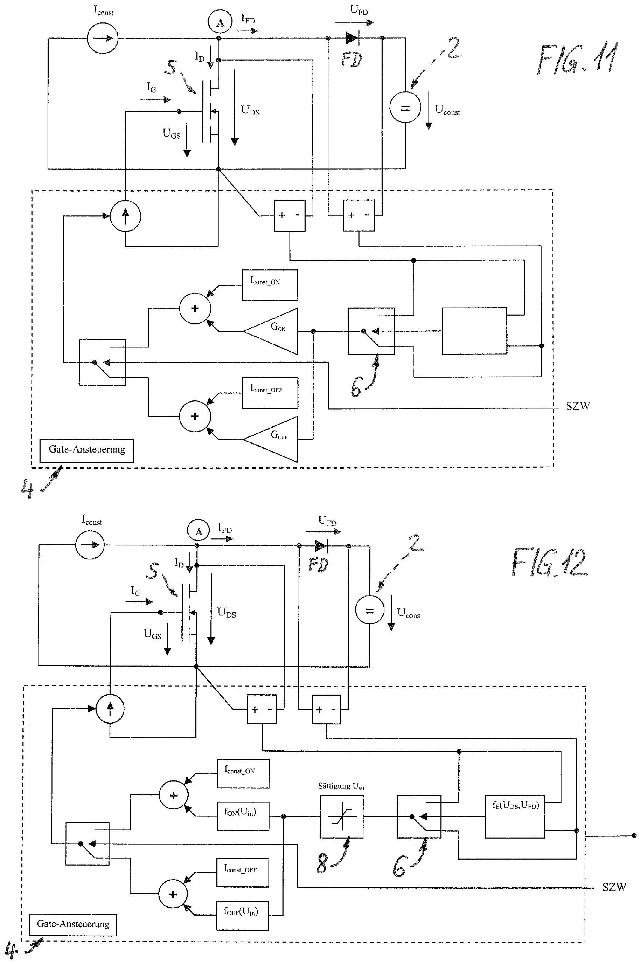

Hierbei wird nun über eine Entscheiderfunktion $f_E$ in Abhängigkeit der Messspannungen eine der beiden erfassten Spannungen (Freilaufdiodenspannung, Drain-Source-, bzw. Kollektor-Emitter-Spannung) auf die bereits vorgestellte Ansteuerungstopologie geschaltet. Die Entscheiderfunktion kann hierbei z. B. ein Umschaltglied 6 umschalten, sobald eine Spannung größer als die jeweils andere wird. Ebenfalls können die Funktionen, welche die aufgeschaltete Spannung in die variablen Steuerstromanteile umwandeln, im einfachsten Fall wieder Gewichtungsfaktoren sein. Somit ergibt sich ein Ansteuerschema nach Fig. 11.

Grundsätzlich kann beispielhaft auch nur eine der beiden Maßnahmen, d. h. Ansteuerstrom in Abhängigkeit von $U_{FD}$ oder von $U_{DS}$, angewandt werden, weil durch jede dieser Maßnahmen allein bereits eine vorteilhafte Spektralabsenkung (dB-Reduzierung) erreicht werden kann.

Erweiterung des Ansteuerschemas um ein Sättigungsglied zur Beschränkung der Flankenformung auf die Anfangs- und/oder Endabschnitte der Flanken

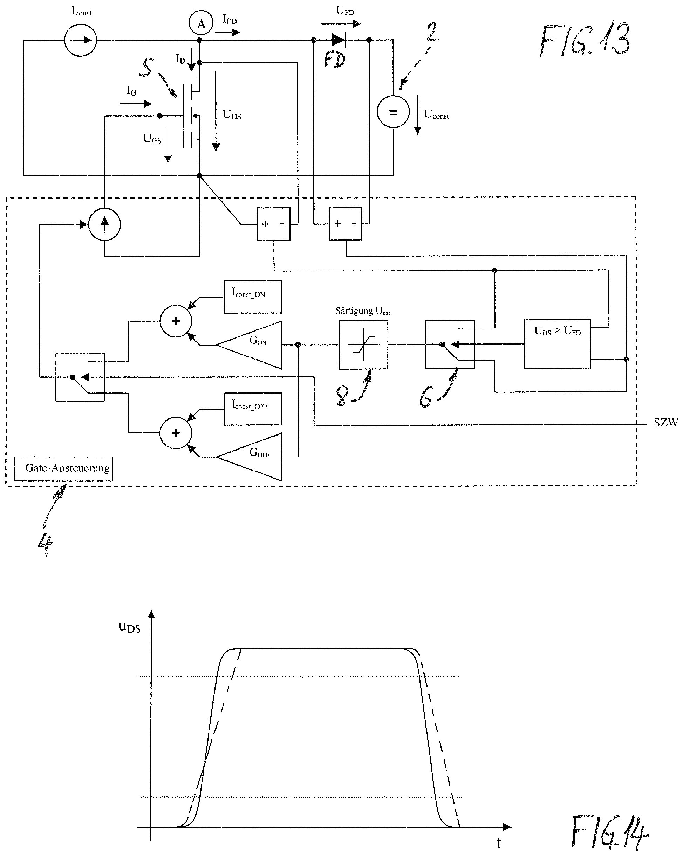

Wie in Fig. 12 bis 14 veranschaulicht ist, kann durch Einführung eines Sättigungsgliedes 8 im Rückführungspfad der erfassten Spannungen die Flankenformung auf die Zeitabschnitte, während die Spannung am jeweiligen erfassten Element kleiner als die eingestellte Sättigungsspannung $U_{sat}$ ist, begrenzt werden. Dazwischen bzw. außerhalb erfolgt die Umschaltung mit einem aus einer konstanten Spannung $U_{sat}$ gewonnenen Gatestrom. Das entstehende allgemeine Ansteuerschema ist in Fig. 12 dargestellt, das für den einfachsten Fall mit konstanten Gewichtungsfunktionen und einer einfachen Entscheiderfunktion in Fig. 13.

Durch die um die Sättigung erweiterte Ansteuerungsschaltung wird ein schnelleres Umschalten mit einer auf die Flankenanfänge und -enden begrenzten Flankenformung erreicht, siehe z. B. die Flankenformung nach Fig. 14.

**Patentansprüche**

1. Elektronischer Schaltkreis (1) mit mindestens einem mit seiner Schaltstrecke (D-S) in Reihe zu einer anzusteuernden induktiven Last (2) liegenden Halbleiterschalter (S) und mindestens einem während Schaltphasen mit dem Halbleiterschalter (S) zusammenwirkenden und dabei ebenfalls in Reihe zu der Last (2) liegenden Freilaufelement (FD), einer Steuerung (4), die dazu ausgebildet ist einen Steueranschluss (G) des Halbleiterschalters (S) mit einem variablen Steuerstrom (iG(t)) in Abhängigkeit vom zeitlichen Verlauf einer an dem Freilaufelement (FD) gemessenen Spannung (uFD(t)) oder einer an der Schaltstrecke (D-S) des Halbleiterschalters (S) gemessenen Spannung (uDS(t)) anzusteuern, **dadurch gekennzeichnet, dass** die Steuerung (4) dazu ausgebildet ist einerseits die Spannung (uFD(t)) an dem Freilaufelement (FD) sowie andererseits auch die Spannung (uDS(t)) an der Schaltstrecke (D-S) des Halbleiterschalters (S) zu messen und während Umschaltphasen bei einem bestimmten Verhältnis der beiden gemessenen Spannungen (uFD(t), uDS(t)) die Abhängigkeit des Steuerstroms (iG(t)) über ein Umschaltglied (6) von der einen Spannung (uFD(t), uDS(t)) auf die andere Spannung (uDS(t), uFD(t)) zu wechseln.

2. Schaltkreis nach Anspruch 1, wobei ferner in einem Rückführungspfad der jeweils erfassten Spannungen (uFD(t), uDS(t)) ein Sättigungsglied (8) angeordnet ist.

3. Schaltkreis nach einem der Ansprüche 1 bis 2, wobei er Bestandteil einer elektronischen Umrichterschaltung (10) vorzugsweise zur Ansteuerung von EC-Motoren ist, wobei die Umrichterschaltung (10) aus einer Brückenschaltung mit mindestens vier oder sechs Halbleiterschaltern (S1 - S6) besteht, die jeweils paarweise mit ihren Schaltstrecken (D-S) in Reihe in zueinander parallelen Brückenpfaden liegen, wobei die Last (2) jeweils zwischen den Halbleiterschaltern jedes Brückenpfads angeschlossen ist, und wobei jeder Halbleiterschalter (S1 - S6) ein parallel geschaltetes Freilaufelement (D1 - D6) aufweist, wobei die Steuerung (4) die Steueranschlüsse (G) der Halbleiterschalter (S1 - S6) derart ansteuert, dass die Last (2) mit einer variierbaren Betriebswechselspannung versorgt wird.

4. Verfahren zum Ansteuern eines Halbleiterschalters (S), der in einem Schaltkreis (1) mit seiner Schaltstrecke (D-S) in Reihe zu einer anzusteuernden induktiven Last (2) liegt, und der während Umschaltphasen mit einem dabei ebenfalls in Reihe zu der Last (2) liegenden Freilaufelement (FD) zusammenwirkt, wobei der Halbleiterschalter (S) zum Umschalten mit einem variablen Steuerstrom (iG(t)) angesteuert wird, der in Abhängigkeit vom zeitlichen Verlauf einer an dem Freilaufelement (FD) gemessenen Spannung (uFD(t)) oder einer an der Schaltstrecke (D-S) des Halbleiterschalters (S) gemessenen Spannung (uDS(t)) vorgegeben wird, **dadurch gekennzeichnet, dass** sowohl die Spannung (uFD(t)) an dem Freilaufelement (FD) als auch die Spannung (uDS(t)) an der Schaltstrecke (D- S) des Halbleiterschalters (S) gemessen werden, wobei während jeder Umschaltphase bei einem bestimmten Verhältnis der beiden gemessenen Spannungen (uFD(t), uDS(t)) die Abhängigkeit des Steuerstroms (iG(t)) von der einen auf die andere Spannung (uDS(t), uFD(t)) gewechselt wird.

5. Verfahren nach Anspruch 4, wobei während jeder Umschaltphase die jeweils gemessenen Spannung (uFD(t), uDS(t)) an dem Freilaufelement (FD) bzw. an der Halbleiter-Schaltstrecke (D-S) mit einer vorgegebenen oder einstellbaren Sättigungsspannung (Usat) verglichen wird, wobei der Steuerstrom (iG(t)) nur variabel vorgesehen wird, wenn die jeweils gemessene Spannung (uFD(t), uDS(t)) kleiner als die Sättigungsspannung (Usat) ist, und wobei ansonsten der Steuerstrom (iG) konstant vorgegeben und insbesondere aus einer konstanten Spannung, insbesondere aus der Sättigungsspannung (Usat), gewonnen wird.

6. Verfahren nach einem der Ansprüche 4 bis 5, wobei der variable Steuerstrom (iG(t)) als Summe eines konstanten Anteils (Iconst) und eines variablen Anteils (i) vorgesehen wird, wobei der variable Anteil eine Funktion (f(uFD), f(uDS)) der jeweils gemessenen Spannung (uFD(t), uDS(t)) über dem Freilaufelement (FD) bzw. der Halbleiter-Schaltstrecke (D-S) ist.

7. Verfahren nach Anspruch 6, wobei der konstante Strom-Anteil (Iconst) und/oder der variable Strom-Anteil (i = f(u)) für einen Einschaltvorgang und einen Ausschaftvorgang unterschiedlich sind.

8. Verfahren nach Anspruch 6 oder 7, wobei die Funktion des variablen Strom-Anteils (i) proportional und im einfachsten Fall ein konstanter Gewichtungsfaktor (G) ist.

9. Verfahren nach Anspruch 6 oder 7, wobei die Funktion des variablen Strom-Anteils (i) ein Polynom beschreibt.

10. Verfahren nach einem der Ansprüche 4 bis 9, mit Anwendung zum Ansteuern von Halbleiterschaltern (S1 - S6) einer Brücken-Umrichterschaltung (10) insbesondere zum Betreiben eines EC-Motors.

**Claims**

1. Electronic circuit (1) comprising at least one semiconductor switch (S), the switching path (D-S) of which is in series with an inductive load (2) to be controlled, and at least one freewheeling element (FD) that interacts with the semiconductor switch (S) during switching phases and is also in series with the load (2), a control unit (4), which is configured to control a control connection (G) of the semiconductor switch (S) with a variable control current (iG(t)) as a function of the time profile of a voltage (uFD(t)) measured at the freewheeling element (FD),
**characterised in that** on the one hand the control unit (4) is configured to measure the voltage (uFD(t)) at the freewheeling element (FD) as well as on the other hand the voltage (uDS(t)) at the switching path (D-S) of the semiconductor switch (S) and the dependence of the control current (iG(t)) being switched using a switching member (6) from one voltage (uFD(t), uDS(t)) to the other voltage (uDS(t) or uFD(t)) during switching phases at a certain ratio of the two measured voltages (uFD(t), uDS(t)).

2. Circuit according to claim 1, wherein further
a saturation member (8) is arranged in a feedback path of the respective measured voltages (uFD(t), uDS(t)).

3. Circuit according to any one of claims 1 to 2, wherein
it is a constituent part of an electronic inverter circuit (10), preferably to control EC motors, the inverter circuit (10) consisting of a bridge circuit with at least four or six semiconductor switches (S1 - S6), which are each in pairs with their switch paths (D-S) in series in bridge paths that are parallel to each other, each load (2) being connected between the semiconductor switches of each bridge path and each semiconductor switch (S1 - S6) having a parallel-connected freewheeling element (D1 - D6), the control unit (4) controlling the control connections (G) of the semiconductor switches (S1 - S6) such that the load (2) is supplied with a variable operating AC voltage.

4. Method for controlling a semiconductor switch (S), which is in an electronic circuit (1) with its switching path (D-S) in series with an inductive load (2) to be controlled and which interacts with a freewheeling element (FD) likewise in series with the load (2) during switching phases
wherein the semiconductor switch (S) is controlled to switch with a variable control current (iG(t)) as a function of the time profile of the voltage (uFD(t)) measured at the freewheeling element (FD), **characterized in that**
both the voltage (uFD(t)) at the freewheeling element (FD) and the voltage (uDS(t)) at the switching path (D-S) of the semiconductor switch (S) are measured, the dependence of the control current (iG(t)) being switched from one voltage (uDS(t), uFD(t)) to the other during each switching phase at a certain ratio of the two measured voltages (uFD(t), uDS(t)).

5. Method according to claim 4, wherein
during each switching phase the respective measured voltage (uFD(t), uDS(t)) at the freewheeling element (FD) and the semiconductor switch path (D-S) is compared with a predefined or adjustable saturation voltage (Usat), the control current (iG(t)) only being variable if the respective measured voltage (uFD(t), uDS(t)) is lower than the saturation voltage (Usat), and the control current (iG) otherwise being specified as constant and in particular being gained from a constant voltage, in particular from the saturation voltage (Usat).

6. Method according to any one of claims 4 to 5, wherein
the variable control current (iG(t)) is provided as a sum of a constant portion (Iconst) and a variable portion (i), the variable portion being a function (f(uFD), f(uDS)) of the respective measured voltage (uFD(t) or uDS(t)) over the freewheeling element (FD) or the semiconductor switching path (D-S).

7. Method according to claim 6, wherein
the constant current portion (Iconst) and/or the variable current portion (i = f(u)) are different for a switching-on process and for a switching-off process.

8. Method according to claim 6 or 7, wherein
the function of the variable current portion (i) is proportional and in the simplest case a constant weighting factor (G).

9. Method according to claim 6 or 7, wherein
the function of the variable current portion (i) describes a polynomial.

10. Method according to any one of claims 4 to 9, with
application to control semiconductor switches (S1 - S6) of a bridge inverter circuit (10), in particular for operating an EC motor.

**Revendications**

1. Circuit électronique (1) comprenant au moins un commutateur à semi-conducteurs (S) en série avec une charge (2) inductive à piloter par son tronçon de commutation (D-S) et au moins un élément de marche à vide (FD) coopérant avec le commutateur à semi-conducteurs (S) au cours de phases de commutation et en série, dans ce cadre, de la même manière, avec la charge (2), une commande (4) qui est réalisée afin de piloter un raccord de commande (G) du commutateur à semi-conducteurs (S) avec un courant de commande (iG(t)) variable en fonction d'une évolution dans le temps d'une tension (uFD(t)) mesurée au niveau de l'élément de marche à vide (FD) ou d'une tension (uDS(t)) mesurée au niveau du tronçon de commutation (D-S) du commutateur à semi-conducteurs (S), **caractérisé en ce que** la commande (4) est réalisée afin de mesurer d'une part la tension (uFD(t)) au niveau de l'élément de marche à vide (FD) ainsi que d'autre part la tension (uDS(t)) au niveau du tronçon de commutation (D-S) du commutateur à semi-conducteurs (S) et afin de changer, au cours de phases de commutation, en présence d'un rapport défini entre les deux tensions (uFD(t), uDS(t)) mesurées, la dépendance du courant de commande

EP 2 783 464 B1

(iG(t)) passant par un organe de commutation (6) depuis une des tensions (uFD(t)), uDS(t)) à l'autre tension (uDS(t), uFD(t)).

2. Circuit de commutation selon la revendication 1, dans lequel
un organe de saturation (8) est disposé en outre dans une voie de retour des tensions (uFD(t)), uDS(t)) respectivement détectées.

3. Circuit de commutation selon l'une quelconque des revendications 1 à 2, dans lequel
ledit circuit de commutation fait partie intégrante d'un circuit mutateur (10) électronique de préférence servant à piloter des moteurs à commutation électronique, dans lequel le circuit mutateur (10) est constitué d'un circuit en pont pourvu au moins de quatre ou de six commutateurs à semi-conducteurs (S1 - S6), qui sont respectivement par paires, par leurs tronçons de commutation (D-S), en série dans des voies de pont parallèles les unes aux autres, dans lequel la charge (2) est raccordée respectivement entre les commutateurs à semi-conducteurs de chaque voie de pont, et dans lequel chaque commutateur à semi-conducteurs (S1 - S6) présente un élément de marche à vide (D1 - D6) branché en parallèle, dans lequel la commande (4) pilotet les raccords de commande (G) des commutateurs à semi-conducteurs (S1 - S6) de telle manière que la charge (2) est alimentée en une tension alternative de fonctionnement variable.

4. Procédé servant à piloter un commutateur à semi-conducteurs (S), qui est en série, dans un circuit de commutation (1), par son tronçon de commutation (D-S), avec une charge (2) inductive à piloter, et qui coopère, au cours de phases de commutation, avec un élément de marche à vide (FD) de la même manière ce faisant en série avec la charge (2),
dans lequel le commutateur à semi-conducteurs (S) est piloté afin de commuter avec un courant de commande (iG(t)) variable, lequel est prédéfini en fonction de l'évolution dans le temps d'une tension (uFD(t)) mesurée au niveau de l'élément de marche à vide (FD) ou d'une tension (uDS(t)) mesurée au niveau du tronçon de commutation (D-S) du commutateur à semi-conducteurs (S), **caractérisé en ce**
**qu'**aussi bien la tension (uFD(t)) au niveau de l'élément de marche à vide (FD) que la tension (D-S) au niveau du tronçon de commutation (D-S) du commutateur à semi-conducteurs (S) sont mesurées, dans lequel la dépendance du courant de commande (iG(t)) d'une des tensions (uDS(t), uFD(t)) est changée à l'autre tension au cours de chaque phase de commutation en présence d'un rapport déterminé entre les deux tensions (uFD(t), uDS(t)) mesurées.

5. Procédé selon la revendication 4, dans lequel la tension (uFD(t)), uDS(t)) respectivement mesurée au niveau de l'élément de marche à vide (FD) ou au niveau du tronçon de commutation à semi-conducteurs (D-S) est comparée, au cours de chaque phase de commutation, à une tension de saturation (Usat) prédéfinie ou pouvant être réglée, dans lequel le courant de commande (iG(t)) est prévu seulement de manière variable quand la tension (uFD(t)), uDS(t)) respectivement mesurée est inférieure à la tension de saturation (Usat), et dans lequel par ailleurs le courant de commande (iG) est prédéfini de marnière constante et est obtenu en particulier à partir d'une tension constante, en particulier de la tension de saturation (USat).

6. Procédé selon l'une quelconque des revendications 4 à 5 dans lequel,
le courant de commande (iG(t)) variable est prévu en tant que somme d'une proportion constante (Iconst) et d'une proportion (i) variable, dans lequel
la proportion variable est une fonction (f(uFD), f(uDS)) de la tension (uFD(t), uDS(t) respectivement mesurée sur l'élément de marche à vide (FD) ou le tronçon de commutation à semi-conducteurs (D-S).

7. Procédé selon la revendication 6, dans lequel la proportion de courant constante (Iconst) et/ou la proportion de courant variable (i = f(u)) est différentes pour une opération de mise en service et pour une opération de mise hors service.

8. Procédé selon la revendication 6 ou 7, dans lequel la fonction de la proportion de courant variable (i) est proportionnelle et est, dans le cas le plus simple, un facteur de pondération (G) constant.

9. Procédé selon la revendication 6 ou 7, dans lequel la fonction de la proportion de courant variable (i) décrit un polynôme.

10. Procédé selon l'une quelconque des revendications 4 à 9, comprenant une application servant à piloter des commutateurs à semi-canducteurs (S1 - S6) d'un circuit mutateur en pont (10) en particulier servant à faire fonctionner un moteur à commutation électronique.

FIG.1

FIG. 2

FIG. 3

FIG. 4a

FIG. 4b

FIG. 4c

FIG. 4d

FIG.5

FIG.6

FIG.7

FIG.8

FIG.9

FIG.10

FIG.11

FIG.12

FIG.13

FIG.14

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 5801458 A